# EUROPEAN PATENT APPLICATION

(11) **EP 4 525 293 A1**
(43) Date of publication of application: **19.03.2025**
(21) Application number: 23830723.5
(22) Date of filing: 17.02.2023
(51) Int. Cl.: H02M 7/48, H01G 2/02, H01G 4/228, H01G 4/38

(54) **POWER MODULE CAPACITOR AND POWER CONVERSION DEVICE PROVIDED WITH SAME**

(30) Priority: 30.06.2022 JP 2022105889
(71) Applicant: Mitsubishi Heavy Industries, Ltd., Tokyo 100-8332 (JP)
(72) Inventor: SANADA, Tomohiko, Tokyo 100-8332 (JP); IIDA, Ryo, Tokyo 100-8332 (JP)
(74) Representative: Studio Torta S.p.A.
(86) International application number: PCT/JP2023/005847
(87) International publication number: WO 2024/004267

(57) **Abstract**

A capacitor according to the present disclosure is provided with: a plurality of capacitor elements arranged side by side in a housing; positive electrode conductors that each connect the positive electrode of each capacitor element with the positive electrode of a power module; negative electrode conductors that each connect the negative electrode of each capacitor element with the negative electrode of the power module while holding the plurality of capacitor elements between the positive and negative electrode conductors; insulation portions that are provided in the housing to fill spaces between the inner surfaces of the housing, the plurality of capacitor elements, the positive electrode conductors, and the negative electrode conductors and thereby insulate the same from each other; and a conductive plate that is formed from a material with higher heat conductivity than the insulation portions and that is disposed, with the intermediation of the insulation portions, between a positive electrode conductor current path extending from each capacitor element to the power module and a negative electrode conductor current path extending from each capacitor element to the power module in the housing such that the insulation portions are interposed between the positive and negative electrode conductors.

## Description

### Technical Field

The present disclosure relates to a power module connection capacitor and a power conversion device provided with the same.

Priority is claimed on Japanese Patent Application No. 2022-105889, filed June 30, 2022, the content of which is incorporated herein by reference.

### Background Art

For example, PTL 1 discloses a capacitor module in which an adjustment member is disposed in proximity to at least one of a plurality of capacitor cells (capacitor elements). By the adjustment member being in proximity to the capacitor cell, the adjust member affects the magnetic flux generated by the loop current flowing through the capacitor cell, resulting in the adjustment of the inductance in the capacitor cell.

### Citation List

### Patent Literature

[PTL 1] Japanese Unexamined Patent Application Publication No. 2013-017319

### Summary of Invention

### Technical Problem

Meanwhile, the capacitor cell of PTL 1 described above is connected to the switching unit via a bus bar (conductor). The inductance in the current path through which the loop current flows may occur more in the bus bar connected to the switching unit than in the capacitor cell.

In addition, in recent years, in the field of power conversion devices including power modules, there has been a growing trend toward higher voltage, larger current capacity, higher frequency, and high-speed switching of power modules to improve added value. Accordingly, the temperature of the bus bar connecting the capacitor cell and the power module serving as the switching unit may further increase. Therefore, in the capacitor module, it is required to suppress an increase in temperature of the bus bars.

The present disclosure has been made to solve the above-described problems, and an object of the present disclosure is to provide a power module connection capacitor and a power conversion device capable of suppressing occurrence of inductance in a conductor that connects capacitor elements and power modules while suppressing an increase in temperature of the conductor.

### Solution to Problem

In order to achieve the above object, a power module connection capacitor according to the present disclosure includes: a housing; a plurality of capacitor elements that are housed in the housing and are disposed adjacent to each other; a positive electrode conductor that connects positive electrodes of the plurality of capacitor elements and positive electrodes of power modules disposed outside the housing; a negative electrode conductor that connects negative electrodes of the plurality of capacitor elements and negative electrodes of the power modules, in a state where the plurality of capacitor elements are held between the positive electrode conductor and the negative electrode conductor; an insulation portion housed in the housing and disposed to fill respective spaces formed between an inner surface of the housing, the plurality of capacitor elements, the positive electrode conductor, and the negative electrode conductor, thereby insulating the housing, the capacitor elements, the positive electrode conductor, and the negative electrode conductor from each other; and a conductive plate housed in the housing, and disposed between a current path of the positive electrode conductor extending from the capacitor elements to the power modules and a current path of the negative electrode conductor extending from the capacitor elements to the power modules, via the positive electrode conductor, the negative electrode conductor, and the insulation portion, in which the conductive plate is formed of a material with higher heat conductivity than the insulation portion.

In order to solve the above problems, according to the present disclosure, there is provided a power conversion device including: the power module connection capacitor; the power modules; and a cooler that cools the power module connection capacitor and the power modules, in which the housing is connected to the cooler, and the conductive plate is disposed integrally with the housing.

### Advantageous Effects of Invention

According to the present disclosure, it is possible to provide a power module connection capacitor and a power conversion device capable of suppressing occurrence of inductance in a conductor that connects capacitor elements and power modules while suppressing an increase in temperature of the conductor.

### Brief Description of Drawings

Fig. 1 is a perspective view illustrating a schematic configuration of a power conversion device according to a first embodiment of the present disclosure.
Fig. 2 is a view illustrating a power module connection capacitor and a power module according to the first embodiment of the present disclosure as viewed from the direction of line II-II illustrated in Fig. 1.
Fig. 3 is a cross-sectional view of the power module connection capacitor in the direction of line III-III illustrated in Fig. 2.
Fig. 4 is a view illustrating an inside of the power module connection capacitor according to a second embodiment of the present disclosure, and is a view corresponding to a partially enlarged portion illustrated in Fig. 2.
Fig. 5 is a view illustrating the inside of the power module connection capacitor according to the second embodiment of the present disclosure, and is a view corresponding to a portion illustrated in Fig. 3.
Fig. 6 is a view illustrating an inside of the power module connection capacitor according to a third embodiment of the present disclosure, and is a view corresponding to a partially enlarged portion illustrated in Fig. 2.
Fig. 7 is a view illustrating the inside of the power module connection capacitor according to the third embodiment of the present disclosure, and is a view corresponding to a portion illustrated in Fig. 3.
Fig. 8 is a view illustrating an inside of the power module connection capacitor according to other embodiments of the present disclosure, and is a view corresponding to a portion illustrated in Fig. 3.
Fig. 9 is a view illustrating the inside of the power module connection capacitor according to other embodiments of the present disclosure, and is a view corresponding to a partially enlarged portion illustrated in Fig. 2.
Fig. 10 is a view illustrating the inside of the power module connection capacitor according to other embodiments of the present disclosure, and is a view corresponding to a portion illustrated in Fig. 3.

### Description of Embodiments

Hereinafter, embodiments of a power module connection capacitor and a power conversion device provided with the same according to the present disclosure will be described with reference to the accompanying drawings.

### [First Embodiment]

### [Power conversion device]

The power conversion device is a device that converts direct current (DC) power into three-phase alternating current (AC) power or the like. Examples of the power conversion device of the present embodiment include an inverter used in a system of a power plant or the like, and an inverter used for driving an electric motor (motor) of an electric vehicle or the like.

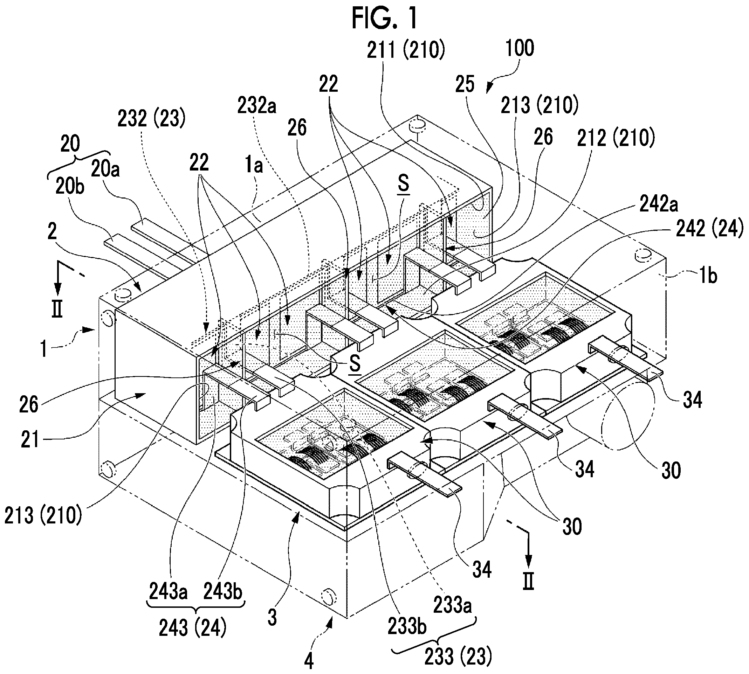

As illustrated in Fig. 1, a power conversion device 100 includes a casing 1, an external input conductor 20, a power module connection capacitor 2, a power conversion unit 3, and a cooler 4. In Fig. 1, the casing 1 and the cooler 4 are indicated by a two-dot chain line.

### (Casing)

The casing 1 forms an outer shell of the power conversion device 100. The casing 1 is formed of a metal such as aluminum or a synthetic resin. The casing 1 in the present embodiment is formed of aluminum and has a rectangular parallelepiped shape. An outer surface of the casing 1 has two side surfaces which are disposed opposite one another.

Hereinafter, for convenience of description, of these two side surfaces, the side surface facing one side is referred to as an "input side surface 1a", and the side surface facing the other side is referred to as an "output side surface 1b". The external input conductor 20 for inputting DC power is led out from the input side surface 1a. The input side surface 1a and the output side surface 1b in the present embodiment are in a parallel relationship.

### (External Input Conductor)

The external input conductors 20 are a pair of electrical conductors that supply DC power supplied from a power system or DC power source such as a battery outside the power conversion device 100, to the power module connection capacitor 2. The external input conductor 20 in the present embodiment is formed of a metal including copper.

The external input conductor 20 includes a first conductor 20a as a positive electrode and a second conductor 20b as a negative electrode. One ends of the first conductor 20a and the second conductor 20b are connected to the power module connection capacitor 2, and the other ends of the first conductor 20a and the second conductor 20b extend to the outside of the casing 1 in a direction intersecting the input side surface 1a of the casing 1. The first conductor 20a and the second conductor 20b in the present embodiment have the same shape.

### (Power Module Connection Capacitor)

The power module connection capacitor 2 is a smoothing capacitor module for storing charge input from the external input conductor 20 and suppressing voltage fluctuation associated with power conversion. The power module connection capacitor 2 is housed in the casing 1.

The DC voltage input from the external input conductor 20 is smoothed and ripple is suppressed by passing through the power module connection capacitor 2, and is then applied to the power conversion unit 3. Hereinafter, for convenience of description, the power module connection capacitor 2 will be simply referred to as the "capacitor 2".

As illustrated in Figs. 1 to 3, the capacitor 2 includes a housing 21, a capacitor element 22, a positive electrode conductor 23, a negative electrode conductor 24, an insulation portion 25, and a conductive plate 26.

### (Housing)

The housing 21 forms an outer shell of the capacitor 2 and houses each of the components constituting the capacitor 2. The housing 21 is formed of, for example, a metal such as aluminum. The housing 21 in the present embodiment has a rectangular (rectangular-shaped) cross section and forms a tubular shape extending from the input side surface 1a to the output side surface 1b when housed in the casing 1. Therefore, the housing 21 has an inner surface 210 and two openings.

The inner surface 210 defines a rectangular parallelepiped shape space for housing each of the components described above other than the housing 21 that the capacitor 2 is provided with. The inner surface 210 is composed of four surfaces. Hereinafter, for convenience of description, of the four surfaces composing the inner surface 210, one inner surface 210 will be referred to as a "top surface 211", and the inner surface 210 facing the top surface 211 will be referred to as a bottom surface 212. The top surface 211 and the bottom surface 212 are, for example, parallel to each other.

In addition, the two inner surfaces 210, which connect the top surface 211 and the bottom surface 212 to each other and face each other, are referred to as "side surfaces 213". The two side surfaces 213 are, for example, parallel to each other, and are, for example, perpendicular to the top surface 211 and the bottom surface 212. The two openings are open in a direction perpendicular to a direction in which the input side surface 1a and the output side surface 1b of the casing 1 extend.

### (Capacitor Element)

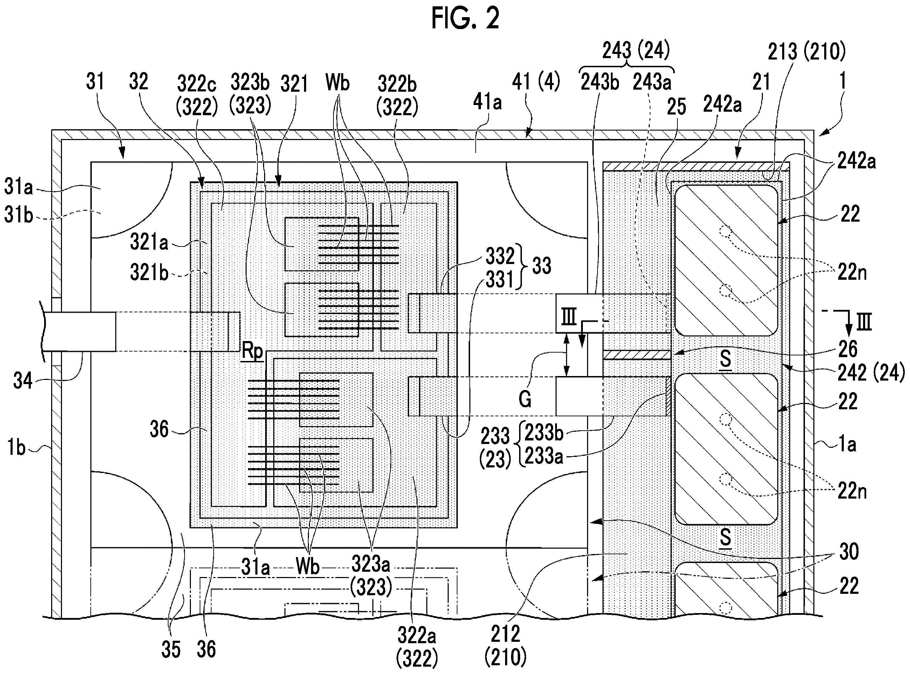

The capacitor element 22 is a film capacitor housed in the housing 21. The capacitor element 22 is disposed between the top surface 211 and the bottom surface 212 on the inner surface 210 and has a columnar shape extending between the top surface 211 and the bottom surface 212. A plurality of the capacitor elements 22 are disposed to be adjacent to each other in the housing 21. As illustrated in Fig. 2, each capacitor element 22 is disposed with an interval S between adjacent capacitor elements 22 in the housing 21.

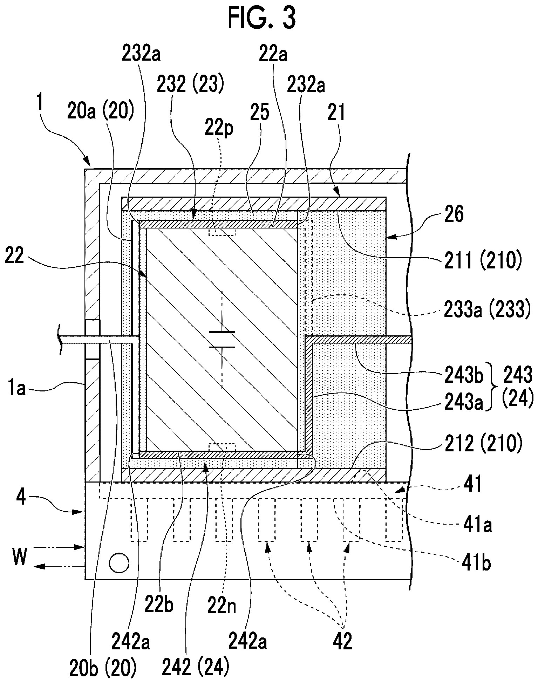

The capacitor element 22 has an upper surface 22a facing the top surface 211 on the inner surface 210 and a lower surface 22b facing a side opposite to the upper surface 22a. That is, the lower surface 22b faces the bottom surface 212 on the inner surface 210. As illustrated in Figs. 2 and 3, the capacitor element 22 includes positive electrodes 22p disposed on the upper surface 22a and negative electrodes 22n disposed on the lower surface 22b.

### (Positive Electrode Conductor)

The positive electrode conductor 23 is a conductor that electrically connects the positive electrodes 22p of the capacitor elements 22 and the positive electrodes of the power modules 30 in the power conversion unit 3 disposed outside the capacitor 2. The positive electrode conductor 23 is formed of, for example, a metal including copper. The positive electrode conductor 23 includes a first plate portion 232 and a P bus bar 233.

The first plate portion 232 in the present embodiment has a flat plate shape. The first plate portion 232 is disposed to extend across the upper surface 22a of each of the plurality of capacitor elements 22 and is connected to each of the positive electrodes 22p of the plurality of capacitor elements 22. The first plate portion 232 is disposed with an interval between the first plate portion 232 and the top surface 211 in the housing 21. The first plate portion 232 has an outer edge portion 232a as a surface corresponding to the thickness portion of the first plate portion 232.

The P bus bar 233 extends integrally with the first plate portion 232 toward the power modules 30 disposed outside the housing 21 from the first plate portion 232. The P bus bar 233 includes a first hanging-down portion 233a and a first connecting portion 233b. The first hanging-down portion 233a extends from the part of the outer edge portion 232a of the first plate portion 232 facing the output side surface 1b, toward the bottom surface 212 on the inner surface 210 of the housing 21.

The first connecting portion 233b extends integrally with the first hanging-down portion 233a from the distal end of the first hanging-down portion 233a toward the output side surface 1b. The first connecting portion 233b extends from the inside of the housing 21, passing through the opening of the housing 21 facing the output side surface 1b, toward the power modules 30. The distal end of the first connecting portion 233b is connected to the positive electrodes of the power modules 30. The first connecting portion 233b in the present embodiment extends in a direction perpendicular to the direction in which the first hanging-down portion 233a extends.

In addition, the one end of the first conductor 20a of the external input conductor 20 is connected to the part of the outer edge portion 232a of the first plate portion 232 facing the input side surface 1a.

### (Negative Electrode Conductor)

The negative electrode conductor 24 is a conductor that electrically connects the negative electrodes 22n of the capacitor elements 22 and the negative electrodes of the power modules 30 in the power conversion unit 3 disposed outside the capacitor 2. The negative electrode conductor 24 is formed of, for example, a metal including copper. The negative electrode conductor 24 includes a second plate portion 242 and an N bus bar 243.

The second plate portion 242 in the present embodiment has a flat plate shape and has the same shape as the first plate portion 232. The second plate portion 242 is disposed to extend across the lower surfaces 22b of the plurality of capacitors 2 and is connected to the respective negative electrodes 22n of the plurality of capacitors 2. The second plate portion 242, together with the first plate portion 232 of the positive electrode conductor 23, holds the plurality of capacitor elements 22 therebetween. The second plate portion 242 is disposed with an interval between the second plate portion 242 and the bottom surface 212 in the housing 21. The second plate portion 242 has an outer edge portion 242a as a surface corresponding to the thickness portion of the second plate portion 242.

The N bus bar 243 extends integrally with the second plate portion 242 toward the power modules 30 disposed outside the housing 21 from the second plate portion 242. The N bus bar 243 and the P bus bar 233 have the same shape. The N bus bar 243 includes a second hanging-down portion 243a and a second connecting portion 243b. The second hanging-down portion 243a extends from the part of the outer edge portion 242a of the second plate portion 242 facing the output side surface 1b, toward the top surface 211 on the inner surface 210 of the housing 21.

The second connecting portion 243b extends integrally with the second hanging-down portion 243a from the distal end of the second hanging-down portion 243a toward the output side surface 1b. The second connecting portion 243b extends from the inside of the housing 21, passing through the opening of the housing 21 facing the output side surface 1b, toward the power modules 30. The distal end of the second connecting portion 243b is connected to the negative electrodes of the power modules 30.

The second connecting portion 243b in the present embodiment extends in a direction perpendicular to the direction in which the second hanging-down portion 243a extends. The second connecting portion 243b is provided in parallel to the first connecting portion 233b with a gap G therebetween. The second connecting portion 243b is arranged parallel to the first connecting portion 233b in a direction in which the side surfaces 213 on the inner surface 210 of the housing 21 face each other.

The gap G created by the parallel arrangement of the second connecting portion 243b and the first connecting portion 233b is secured with a spatial distance (insulation distance). The dimension of the gap G in the present embodiment is, for example, 1 mm or more and 10 mm or less.

When an insulating member (not illustrated), formed of materials such as insulating paper or synthetic resin, is disposed between the first connecting portion 233b and the second connecting portion 243b to fill the gap G, the dimension of the gap G may be greater than 0 mm and less than 1 mm, for example.

The one end of the second conductor 20b of the external input conductor 20 is connected to the part of the outer edge portion 242a of the second plate portion 242 facing the input side surface 1a.

### (Insulation Portion)

The insulation portion 25 is an insulating member that is housed in the housing 21. The insulation portion 25 is formed of a synthetic resin material or the like. The insulation portion 25 in the drawings is indicated by hatching due to space limitations on the paper.

The insulation portion 25 is disposed to fill the respective spaces formed between the inner surface 210 of the housing 21, the plurality of capacitor elements 22, the positive electrode conductor 23, and the negative electrode conductor 24, thereby insulating the housing 21, the capacitor elements 22, the positive electrode conductor 23, and the negative electrode conductor 24 from each other. That is, the insulation portion 25 is interposed between each of the components constituting the capacitor 2. At the same time, the insulation portion 25 supports and positions each of the components constituting the capacitor 2 in the housing 21.

The insulation portion 25 is formed after a potting material is filled into the housing 21, and a predetermined temperature and time are applied, causing the potting material to cure. As the potting material, for example, a silicon gel or an epoxy resin is used.

For example, the potting material is filled into the housing 21 from the upper side through the other opening, with one opening of the housing 21 closed using a predetermined member, and the other opening oriented upward in the vertical direction.

### (Conductive Plate)

As illustrated in Figs. 1 to 3, the conductive plate 26 is housed in the housing 21 and is a conductive member having a flat plate shape. The conductive plate 26 in the present embodiment is disposed between the P bus bar 233 in the positive electrode conductor 23 and the N bus bar 243 in the negative electrode conductor 24, via the insulation portion 25.

Specifically, the conductive plate 26 is disposed to extend across the gap G between the first connecting portion 233b of the P bus bar 233 and the second connecting portion 243b of the N bus bar 243, between the first hanging-down portion 233a of the P bus bar 233 and the side surface 213 in the housing 21, and between the second hanging-down portion 243a of the N bus bar 243 and the side surface 213 in the housing 21.

In addition, the conductive plate 26 is disposed integrally with the housing 21 in a state where the top surface 211 and the bottom surface 212 on the inner surface 210 of the housing 21 are connected to each other. The conductive plate 26 is formed of a material having higher heat conductivity than the insulation portion 25. The conductive plate 26 according to the present embodiment is formed of the same material as the housing 21. Therefore, the conductive plate 26 is formed of aluminum.

Therefore, the conductive plate 26 is disposed between the current path of the positive electrode conductor 23 extending from the capacitor elements 22 to the power modules 30 and the current path of the negative electrode conductor 24 extending from the capacitor elements 22 to the power modules 30, via the positive electrode conductor 23, the negative electrode conductor 24, and the insulation portion 25.

### (Power Conversion Unit)

The power conversion unit 3 converts the power input from the capacitor 2 and outputs the converted power to the outside. The power conversion unit 3 is housed in the casing 1. In order to output three-phase AC power, the power conversion unit 3 in the present embodiment includes three power modules 30 respectively responsible for outputs for a U phase, a V phase, and a W phase. Therefore, the power conversion device 100 in the present embodiment is a three-phase inverter including three power modules 30.

### (Power Module)

The power module 30 converts input power and outputs the converted power. As illustrated in Fig. 2, the power module 30 includes a base plate 31, a circuit board 32, an external output conductor 34, a resin case 35, a sealing portion 36, and a bonding wire Wb.

The base plate 31 is a member having a flat plate shape. The base plate 31 has a front surface 31a and a back surface 31b positioned on a back side of the front surface 31a. That is, the front surface 31a and the back surface 31b of the base plate 31 are back-to-back in a state of being parallel to each other. The back surface 31b of the base plate 31 is fixed to the cooler 4 via a bonding material or the like (not illustrated). For example, a metal including copper or the like is adopted for the base plate 31 in the present embodiment. The metal including aluminum or the like may be adopted for the base plate 31.

The circuit board 32 includes an insulating plate 321, a front surface pattern 322, a power semiconductor element 323, and a back surface pattern (not illustrated).

The insulating plate 321 has a flat plate shape. The insulating plate 321 has a first surface 321a and a second surface 321b positioned on the back side of the first surface 321a. That is, the first surface 321a and the second surface 321b of the insulating plate 321 are back-to-back in a state of being parallel to each other. On the second surface 321b of the insulating plate 321, a back surface pattern which is a pattern of copper foil or the like is formed on one surface. The back surface pattern is fixed to the center of the front surface 31a of the base plate 31 via a bonding material.

The insulating plate 321 in the present embodiment is formed of, for example, an insulating material such as ceramic. As the insulating material forming the insulating plate 321, paper phenol, paper epoxy, glass composite, glass epoxy, glass polyimide, fluororesin, or the like can be adopted in addition to ceramic.

The front surface pattern 322 is a pattern of copper foil or the like formed on the first surface 321a of the insulating plate 321 and extending in a planar shape. The front surface pattern 322 is formed by, for example, being fixed to the first surface 321a of the insulating plate 321 through bonding or the like and then being subjected to etching or the like.

A plurality of the front surface patterns 322 are disposed on the first surface 321a of the insulating plate 321. The plurality of front surface patterns 322 are disposed adjacent to each other with an interval therebetween in a direction in which the insulating plate 321 extends. In the present embodiment, a case where three front surface patterns 322 are disposed on the first surface 321a will be described as an example. Hereinafter, for convenience of description, these three front surface patterns 322 are referred to as a first front surface pattern 322a, a second front surface pattern 322b, and a third front surface pattern 322c.

The first front surface pattern 322a and the second front surface pattern 322b are patterns for exchanging DC current input and output with the capacitor 2 and correspond to the inlet or outlet portions in the loop between P and N formed on the front surface pattern 322. The external output conductor 34 for outputting the AC current converted by the power semiconductor element 323 to a load (not illustrated), such as an AC rotary electric machine provided outside the power conversion device 100, is connected to the third front surface pattern 322c.

The power semiconductor element 323 is a circuit element that converts power by means of a switching operation of turning on and off a voltage or a current. The power semiconductor element 323 is, for example, a switching element such as an IGBT or a MOSFET. In the present embodiment, as an example, a case where a MOSFET is applied as the power semiconductor is illustrated, and four power semiconductor elements 323 are connected to the front surface pattern 322 of the circuit board 32. In the case of using IGBTs, it is necessary to arrange a diode that flows current in the opposite direction to the IGBT in parallel.

The four power semiconductor elements 323 in the present embodiment include two first power semiconductor elements 323a and two second power semiconductor elements 323b. The first power semiconductor element 323a is connected to the first front surface pattern 322a. The second power semiconductor element 323b is connected to the third front surface pattern 322c.

When the power semiconductor element 323 is a MOSFET, the power semiconductor element 323 has an input surface on which an input terminal corresponding to the drain (not illustrated) is formed, an output surface on which an output terminal corresponding to the source (not illustrated) is formed, and a gate corresponding to a control signal input terminal for controlling the switching of the power semiconductor element 323.

The input surface of the power semiconductor element 323 is electrically connected to the front surface pattern 322 via the bonding material S. One end of a bonding wire Wb as an electrical lead is electrically connected to the output surface of the power semiconductor element 323. The bonding wire Wb is formed of a metal including aluminum or the like. That is, the front surface patterns 322 formed on the first surface 321a are electrically connected to each other by wire bonding.

The input surface of the first power semiconductor element 323a is connected to the first front surface pattern 322a. The other end of the bonding wire Wb, one end of which is connected to the output surface of the first power semiconductor element 323a, is connected to the third front surface pattern 322c. The input surface of the second power semiconductor element 323b is connected to the third front surface pattern 322c. The other end of the bonding wire Wb, one end of which is connected to the output surface of the second power semiconductor element 323b, is connected to the second front surface pattern 322b.

DC power is input to the first power semiconductor element 323a via the first front surface pattern 322a, and DC power is input to the second power semiconductor element 323b via the second front surface pattern 322b and the bonding wire Wb connecting the second front surface pattern 322b and the second power semiconductor element 323b. The first power semiconductor element 323a and the second power semiconductor element 323b perform a switching operation, whereby the DC power is converted into AC power and output to the third front surface pattern 322c.

A control signal generated by a control unit (not illustrated), including a gate drive circuit board provided outside the circuit board 32, is input to the power semiconductor element 323. The power semiconductor element 323 performs switching in accordance with the control signal. When the power semiconductor element 323 is an IGBT, the power semiconductor element 323 includes an input surface corresponding to a collector, an output surface corresponding to an emitter, and a gate corresponding to a control signal input terminal.

The bonding material used for the bonding of the surface 31a of the base plate 31 and the back surface pattern formed on the second surface 321b of the insulating plate 321, the bonding of the power semiconductor element 323 and the front surface pattern 322, and the bonding of the back surface 31b of the base plate 31 and the cooler 4 can adopt, for example, solder or sintered materials (such as metal powders).

The main terminal portion 33 is an electrical conductor that exchanges DC power between the capacitor 2 and the circuit board 32. The main terminal portion 33 is formed of a metal including copper or the like. The main terminal portion 33 has a P terminal 331 as a positive electrode of the power module 30 and an N terminal 332 as a negative electrode of the power module 30. The P terminal 331 and the N terminal 332 are arranged in parallel with a gap that has the same interval as the gap G.

The P terminal 331 is connected to the first connecting portion 233b of the P bus bar 233 of the capacitor 2, for example, by a fastening part such as a bolt. The N terminal 332 is connected to the second connecting portion 243b of the N bus bar 243 of the capacitor 2, for example, by a fastening part such as a bolt. In Fig. 2, the illustrations of the connection portion between the P terminal 331 and the first connecting portion 233b, and the connection portion between the N terminal 332 and the second connecting portion 243b, are omitted.

The external output conductor 34 is an electrical conductor for outputting the AC power, after being converted by the power semiconductor element 323, to the outside of the power conversion device 100. The external output conductor 34 is formed of a metal including copper. One end of the external output conductor 34 is connected to the third front surface pattern 322c of the circuit board 32. As illustrated in Fig. 1, the other end of the external output conductor 34 extends to the outside of the casing 1 in a direction intersecting the output side surface 1b. For example, a wire (not illustrated) for power output connected to a load such as a motor is connected to the other end of the external output conductor 34.

As illustrated in Fig. 2, the resin case 35 is a member that mechanically reinforces the external output conductor 34 and the main terminal portion 33 in a state of being fixed to the front surface 31a of the base plate 31. The resin case 35 is made of, for example, a synthetic resin material (insulating material). For example, polyphenylene sulfide (PPS) can be adopted as the material forming the resin case 35 in the present embodiment. A synthetic resin material other than PPS may be adopted for the resin case 35. The resin case 35 is fixed to the front surface 31a of the base plate 31 by, for example, an adhesive agent.

The resin case 35 surrounds the circuit board 32 from the outer side, while covering the P terminal 331 and N terminal 332 of the main terminal portion 33 and the external output conductor 34 from the outer side. The resin case 35 forms a resin case 35 that surrounds the circuit board 32 from the surrounding in a direction along the surface 31a of the base plate 31. Therefore, the resin case 35, together with the base plate 31, defines the space in which the circuit board 32 is housed. In the present embodiment, for convenience of description, the space in which the circuit board 32 is housed is referred to as a "potting space Rp".

The sealing portion 36 is an insulating member disposed in the potting space Rp. The potting space Rp is filled with a liquid potting material from the outside (potting), and the exposed members in the potting space Rp are sealed. The potting material filled in the potting space Rp is cured by applying a predetermined temperature and time, and electrically insulates the spaces between the respective members in the potting space Rp and the spaces between the respective members and the spaces outside the power modules 30. As the potting material in the present embodiment, the same potting material as the potting material that is filled in the housing 21 of the capacitor 2 can be adopted.

Therefore, the sealing portion 36 is formed by this potting material. The sealing portion 36 in the potting space Rp is disposed to cover the respective surfaces of the circuit board 32, the bonding wire Wb, the external output conductor 34, and the main terminal portion 33.

### (Cooler)

The cooler 4 is a device that cools the capacitor 2 and the power modules 30 in the power conversion unit 3. As illustrated in Fig. 1, the cooler 4 is provided to be stacked on the casing 1, and is fixed to and integrated with the casing 1. As illustrated in Fig. 3, the cooler 4 includes a base portion 41 and heat dissipation fins 42. In Fig. 3, the base portion 41 and the heat dissipation fins 42 are indicated by a dotted line.

The base portion 41 has a plate shape. The base portion 41 includes a bonding surface 41a and a heat dissipation surface 41b. The bonding surface 41a is a surface that is bonded to the outer surface of the housing 21 of the capacitor 2 and the back surface 31b of the base plate 31 of the power modules 30 via a bonding material or the like (see also Fig. 2). The heat dissipation surface is a surface facing a side opposite to the bonding surface 41a. That is, the base portion 41 of the cooler 4 is connected to the housing 21 of the capacitor 2 and the base plate 31 of the power modules 30.

The bonding surface 41a and the heat dissipation surface 41b are back-to-back in a state of being parallel to each other. The heat dissipation fins 42 are columnar members disposed in plurality on the heat dissipation surface 41b of the base portion 41. Each of the heat dissipation fins 42 protrudes from the heat dissipation surface 41b to the side opposite to the capacitor 2 and the power modules 30, with the base portion 41 as the center.

For example, a liquid refrigerant W such as water is introduced into the cooler 4 from the outside. The heat dissipation surface 41b of the base portion 41 and the heat dissipation fins 42 are cooled by coming into contact with the liquid refrigerant W introduced from the outside. The liquid refrigerant W is warmed by exchanging heat with the heat conducted from the capacitor 2 and the power modules 30 to the base portion 41 and the heat dissipation fins 42, while simultaneously cooling the capacitor 2 and the power modules 30.

### (Operations and Effects)

The DC power input to the first plate portion 232 of the positive electrode conductor 23 through the first conductor 20a of the external input conductor 20 as the positive electrode is input to the P terminal 331, which is the positive electrode of the power module 30, through the first hanging-down portion 233a and the first connecting portion 233b of the P bus bar 233. In addition, the DC power input to the positive electrode conductor 23 is input to the capacitor elements 22 from the positive electrodes 22p of the capacitor elements 22. The DC power input from the P terminal 331 to the front surface pattern 322 is converted into AC power by the power semiconductor element 323. This AC power is used as a load of an external AC rotating electric machine or the like of the power conversion device 100 through the external output conductor 34 connected to the front surface pattern 322. The AC power returning from the external load is input to the front surface pattern 322 again through the external output conductor 34, is converted into DC power by the power semiconductor element 323, and is then input to the N terminal 332. The DC power input to the N terminal 332 flows through the negative electrode conductor 24 and the second conductor 20b of the external input conductor 20. The DC power input from the positive electrodes 22p of the capacitor elements 22 is repeatedly discharged through the negative electrodes 22n while being stored as charge (charging) in the capacitor element 22. The charging and discharging of the capacitor elements 22 is repeated, whereby the DC current flowing through the positive electrode conductor 23 and the negative electrode conductor 24 is smoothed. When the DC current flows through the P bus bar 233 of the positive electrode conductor 23 and the N bus bar 243 of the negative electrode conductor 24, a magnetic flux is generated from each of the P bus bar 233 and the N bus bar 243.

With the above configuration, since the conductive plate 26 is disposed between the P bus bar 233 and the N bus bar 243, the magnetic flux generated by the current flowing through the P bus bar 233 and the N bus bar 243 links with the conductive plate 26. Accordingly, the induced current (back electromotive force) in accordance with the amount of magnetic flux linked with the conductive plate 26 flows through the conductive plate 26, and the magnetic flux from the P bus bar 233 and the N bus bar 243 is canceled out by the magnetic flux generated by the induced current. That is, the density of the magnetic flux generated by the current flowing through the P bus bar 233 and the N bus bar 243 in the housing 21 decreases. As a result, the inductance in the positive electrode conductor 23 and the negative electrode conductor 24 is reduced.

In addition, the heat generated in the P bus bar 233 and the N bus bar 243 is conducted to the conductive plate 26 through the insulation portion 25. The heat conducted to the conductive plate 26 spreads within the conductive plate 26. With the above configuration, since the conductive plate 26 has a higher heat conductivity than the insulation portion 25, the heat generated from the P bus bar 233 and the N bus bar 243 can spread more in the housing 21 as compared to a configuration in which the conductive plate 26 is not disposed. That is, the P bus bar 233 and the N bus bar 243 can be further cooled.

Therefore, it is possible to suppress the occurrence of inductance in the conductor that connects the capacitor elements 22 and the power modules 30 while suppressing the increase in temperature of the conductor.

In addition, with the above configuration, since the housing 21 and the conductive plate 26 connected to the cooler 4 are integrated, the housing 21 is cooled by the cooler 4 while the heat conducted from the P bus bar 233 and the N bus bar 243 to the conductive plate 26 is released to the housing 21. Therefore, it is possible to further suppress the increase in temperature of the conductor.

### [Second Embodiment]

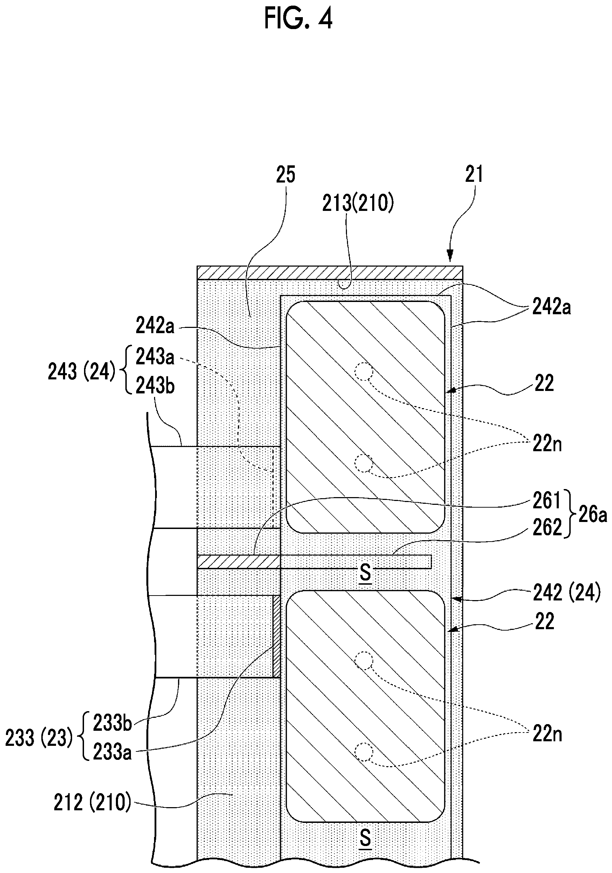

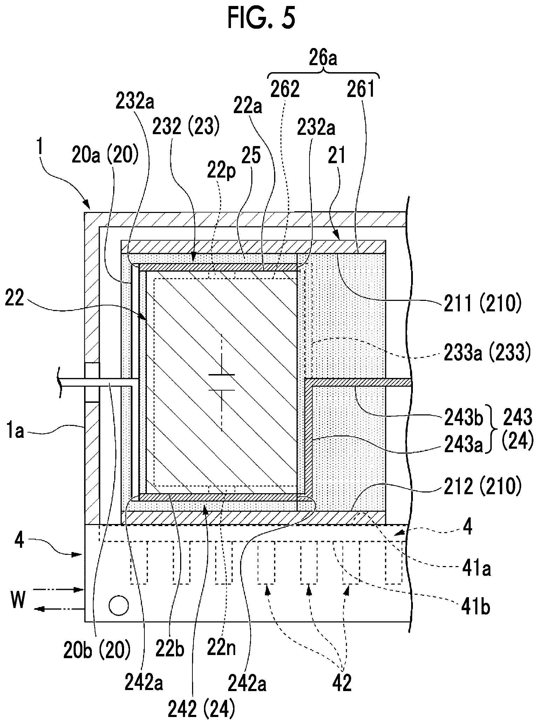

Next, a second embodiment of the power conversion device 100 according to the present disclosure will be described with reference to Fig. 4 and Fig. 5. In the second embodiment described below, configurations common to the first embodiment described above will be denoted by the same reference numerals in the drawings and the description thereof will be omitted. In the second embodiment, the configuration of the conductive plate 26a in the capacitor 2 is different from the configuration of the conductive plate 26 described in the first embodiment.

### (Conductive Plate)

The conductive plate 26a is housed in the housing 21. The conductive plate 26a is formed of a material having higher heat conductivity than the insulation portion 25 and is formed of the same material as the housing 21. The conductive plate 26a in the present embodiment includes a first portion 261 and a second portion 262.

The first portion 261 is a conductive member having a flat plate shape. The first portion 261 is disposed between the P bus bar 233 in the positive electrode conductor 23 and the N bus bar 243 in the negative electrode conductor 24, via the insulation portion 25.

Specifically, the first portion 261 is disposed in the gap G between the first connecting portion 233b of the P bus bar 233 and the second connecting portion 243b of the N bus bar 243, between the first hanging-down portion 233a of the P bus bar 233 and the side surface 213 in the housing 21, and between the second hanging-down portion 243a of the N bus bar 243 and the side surface 213 in the housing 21.

Therefore, the first portion 261 is disposed between the current path of the positive electrode conductor 23 and the current path of the negative electrode conductor 24 on the side of the power modules 30, with respect to the capacitor elements 22. In addition, the first portion 261 is disposed integrally with the housing 21 in a state where the top surface 211 and the bottom surface 212 on the inner surface 210 of the housing 21 are connected to each other.

The second portion 262 is a conductive member that is integrally formed with the first portion 261. The second portion 262 is disposed in the interval S between adjacent capacitor elements 22. The second portion 262 in the present embodiment is disposed between the adjacent capacitor elements 22 via the insulation portion 25, to separate the capacitor elements 22 adjacent to each other. Further, the second portion 262 is held between the first plate portion 232 of the positive electrode conductor 23 and the second plate portion 242 of the negative electrode conductor 24, via the insulation portion 25.

As illustrated in Fig. 5, the conductive plate 26a, composed of the first portion 261 and the second portion 262, has a T-shape when viewed from a direction in which the side surfaces 213 of the inner surface 210 of the housing 21 face each other.

### (Operations and Effects)

With the above configuration, since the second portion 262 of the conductive plate 26a is disposed between the capacitor elements 22 adjacent to each other, the magnetic flux generated by the current flowing through the capacitor elements 22 links with the second portion 262. Accordingly, the induced current (back electromotive force) in accordance with the amount of magnetic flux linked with the second portion 262 flows through the second portion 262, and the magnetic flux from the capacitor elements 22 is canceled out by the magnetic flux generated by the induced current. That is, the density of the magnetic flux generated by the current flowing through the capacitor elements 22 decreases. As a result, the inductance in the capacitor elements 22 as the current path is reduced.

In addition, the heat generated in the capacitor elements 22 is conducted to the second portion 262 of the conductive plate 26a through the insulation portion 25. The heat conducted to the second portion 262 spreads within the second portion 262. With the above configuration, since the second portion 262 has a higher heat conductivity than the insulation portion 25, the heat generated from the capacitor elements 22 can spread more in the housing 21 as compared to a configuration in which the second portion 262 is not disposed between the capacitor elements 22. That is, the capacitor elements 22 can be further cooled.

In addition, with the above configuration, since the housing 21 and the first portion 261 of the conductive plate 26a connected to the cooler 4 are integrated, and the first portion 261 and the second portion 262 are integrated, the heat conducted to the housing 21 from the P bus bar 233 and the N bus bar 243 to the first portion 261, as well as the heat conducted from the capacitor elements 22 to the second portion 262, can be released to the housing 21. Therefore, it is possible to further suppress the increase in temperature of the conductor and the capacitor elements 22.

### [Third Embodiment]

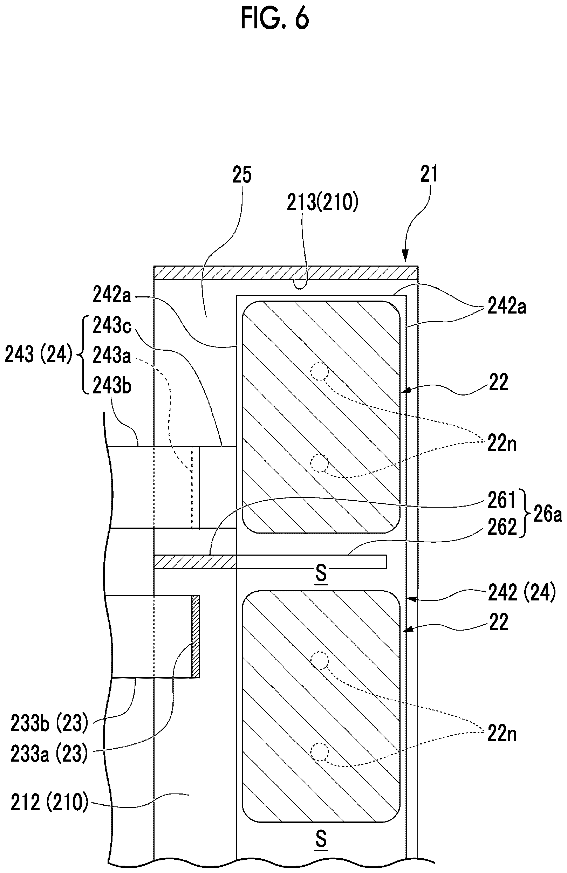

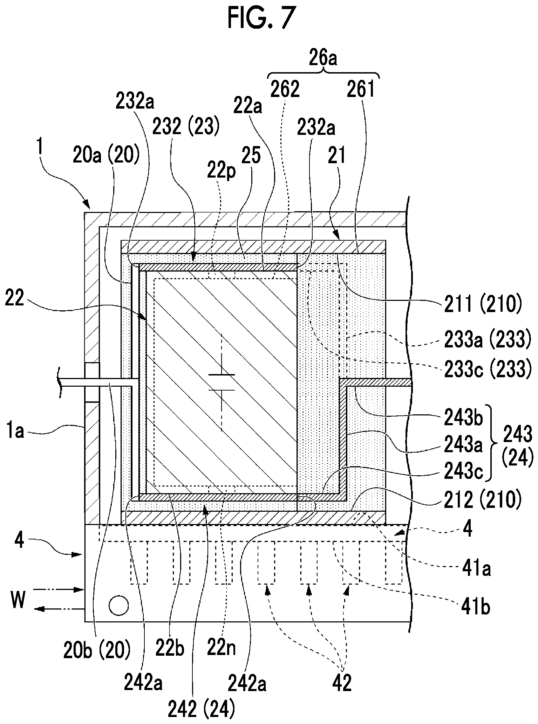

Next, a third embodiment of the power conversion device 100 according to the present disclosure will be described with reference to Fig. 6 and Fig. 7. In the third embodiment described below, configurations common to the second embodiment described above will be denoted by the same reference numerals in the drawings and the description thereof will be omitted. In the third embodiment, the configurations of the P bus bar 233 of the positive electrode conductor 23 and the N bus bar 243 of the negative electrode conductor 24 are different from the configurations of the P bus bar 233 and the N bus bar 243 described in the second embodiment.

The P bus bar 233 in the present embodiment includes a first extending portion 233c, a first hanging-down portion 233a, and a first connecting portion 233b. The first extending portion 233c extends from the part of the outer edge portion 232a of the first plate portion 232 facing the output side surface 1b, toward the output side surface 1b. The first hanging-down portion 233a extends from the distal end of the first extending portion 233c toward the bottom surface 212 of the inner surface 210 of the housing 21 integrally with the first extending portion 233c.

The first connecting portion 233b extends integrally with the first hanging-down portion 233a from the distal end of the first hanging-down portion 233a toward the output side surface 1b. The first connecting portion 233b extends from the inside of the housing 21, passing through the opening of the housing 21 facing the output side surface 1b, toward the power modules 30. The distal end of the first connecting portion 233b is connected to the positive electrodes of the power modules 30. The first connecting portion 233b in the present embodiment extends in a direction perpendicular to the direction in which the first hanging-down portion 233a extends. In addition, the first connecting portion 233b extends in the same direction as the direction in which the first extending portion 233c extends.

The N bus bar 243 and the P bus bar 233 in the present embodiment have the same shape. The N bus bar 243 includes a second extending portion 243c, a second hanging-down portion 243a, and a second connecting portion 243b. The second extending portion 243c extends from the part of the outer edge portion 242a of the second plate portion 242 facing the output side surface 1b, toward the output side surface 1b. The second hanging-down portion 243a extends from the distal end of the second extending portion 243c toward the top surface 211 of the inner surface 210 of the housing 21 integrally with the second extending portion 243c.

The second connecting portion 243b extends integrally with the second hanging-down portion 243a from the distal end of the second hanging-down portion 243a toward the output side surface 1b. The second connecting portion 243b extends from the inside of the housing 21, passing through the opening of the housing 21 facing the output side surface 1b, toward the power modules 30.

The second connecting portion 243b in the present embodiment extends in a direction perpendicular to the direction in which the second hanging-down portion 243a extends. The second connecting portion 243b is provided in parallel to the first connecting portion 233b with a gap G therebetween. The second connecting portion 243b is arranged parallel to the first connecting portion 233b in a direction in which the side surfaces 213 on the inner surface 210 of the housing 21 face each other.

### (Operations and Effects)

With the configuration of the third embodiment, the area of the first portion 261 in the conductive plate 26a disposed between the capacitor elements 22 can be increased with respect to the configuration described in the second embodiment. For example, the surface area of the first portion 261 of the conductive plate 26a can be increased by the length of the first extending portion 233c and the second extending portion 243c. Therefore, the amount of the magnetic flux acting (linking) on the conductive plate 26a from the capacitor elements 22, the P bus bar 233, and the N bus bar 243 can be increased. As a result, the inductance can be further reduced.

In addition, compared to the configuration described in the second embodiment, the sections adjacent to each other in the facing direction of the side surfaces 213 of the housing 21 become shorter by the length of the first extending portion 233c and the length of the second extending portion 243c. Therefore, for example, when current flows through the P bus bar 233 and the N bus bar 243 and heat is generated, it is possible to suppress the heat conducted from the P bus bar 233 and the N bus bar 243 to the first portion 261 of the conductive plate 26a via the insulation portion 25 from becoming concentrated.

### (Other Embodiments)

The embodiments of the present disclosure have been described in detail above with reference to the drawings. However, specific configurations are not limited to the configurations of the embodiments, and additions, omissions, and substitutions of components and other modifications can be made without departing from the scope of the present disclosure.

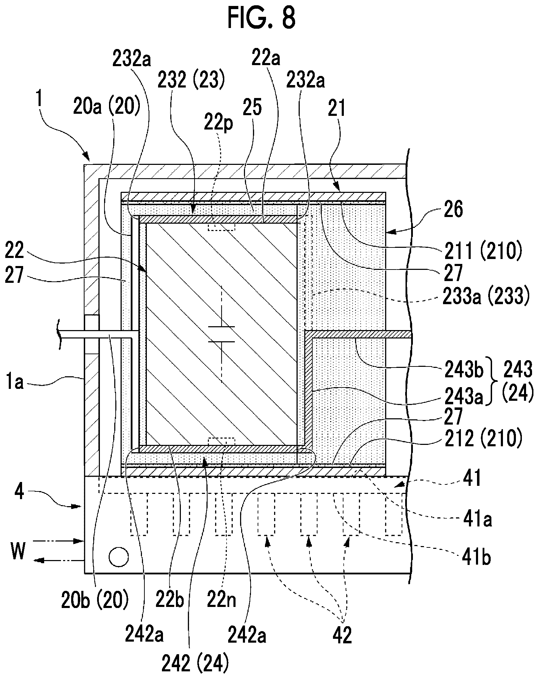

As illustrated in Fig. 8, the capacitor 2 described in the above embodiment may further include a housing insulating layer 27 that is disposed on the inner surface 210 of the housing 21 integrally with the housing 21. In this case, the housing insulating layer 27 is an oxide of a metallic material forming the housing 21. When the housing 21 is formed of aluminum, the housing 21 is an oxide (anodic oxide film) formed by anodizing the aluminum forming the housing 21. As a result, it is possible to increase insulation between the positive electrode conductor 23, the negative electrode conductor 24, and the housing 21. Therefore, the distance between the top surface 211 and the bottom surface 212 on the inner surface 210 of the housing 21, and the first plate portion 232 of the positive electrode conductor 23 and the second rank plate portion of the negative electrode conductor 24 can be shortened. As a result, it is possible to increase the amount of magnetic flux linking with the top surface 211 and the bottom surface 212 of the inner surface 210 of the housing 21, within the magnetic flux generated by the current flowing through the first plate portion 232 and the second plate portion 242, thereby reducing the inductance. The housing insulating layer 27 may also be an insulating coating material formed of a synthetic resin material or the like.

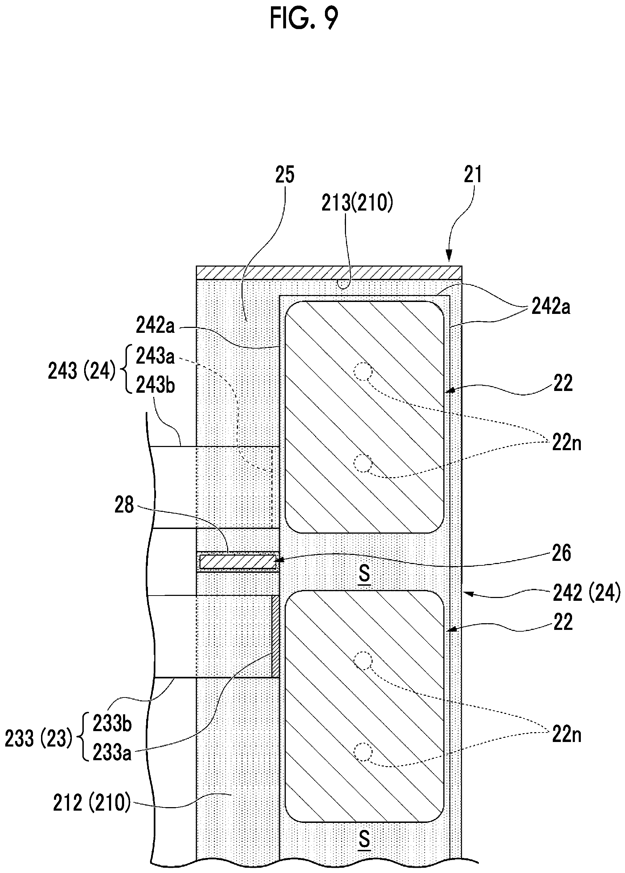

In addition, as illustrated in Fig. 9, the capacitor 2 described in the first embodiment may further include a conductive plate insulating layer 28 that is disposed on the surface of the conductive plate 26 integrally with the conductive plate 26. In this case, the conductive plate insulating layer 28 is an oxide of a metallic material forming the conductive plate 26. When the conductive plate 26 is formed of aluminum, the housing 21 is an oxide (anodic oxide film) formed by anodizing the aluminum forming the conductive plate 26. As a result, it is possible to increase insulation between the P bus bar 233 of the positive electrode conductor 23, the N bus bar 243 of the negative electrode conductor 24, and the conductive plate 26. Therefore, the distance between the conductive plate 26, and the P bus bar 233 and the N bus bar 243 can be shortened. As a result, it is possible to increase the amount of magnetic flux linking with the conductive plate 26, within the magnetic flux generated by the current flowing through the P bus bar 233 and the N bus bar 243, thereby reducing the inductance. The conductive plate insulating layer 28 may also be an insulating coating material formed of a synthetic resin material or the like. In addition, the conductive plate insulating layer 28 may be disposed integrally with the conductive plate 26a on the surface of the conductive plate 26a described in the second embodiment.

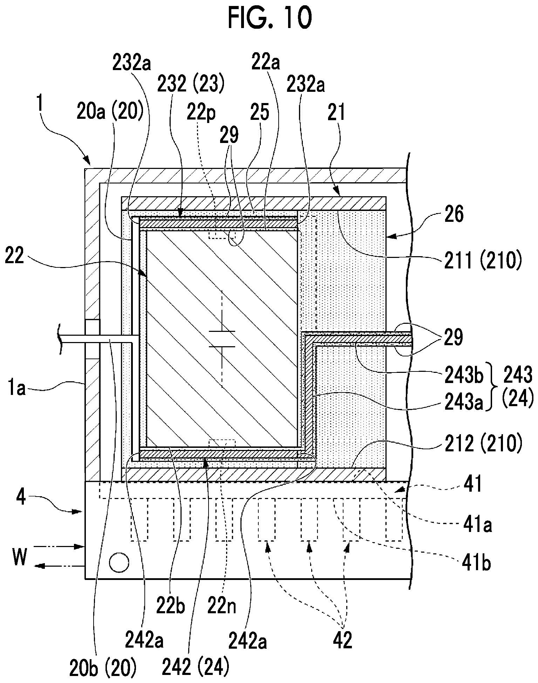

In addition, as illustrated in Fig. 10, the capacitor 2 described in the above embodiment may further include a conductor insulating layer 29 that is disposed integrally with the positive electrode conductor 23 and the negative electrode conductor 24 on the outer surfaces of the positive electrode conductor 23 and the negative electrode conductor 24. In this case, the conductor insulating layer 29 is an insulating coating material formed of a synthetic resin material or the like. As a result, it is possible to increase insulation between the positive electrode conductor 23 and the negative electrode conductor 24. Therefore, the distance between the top surface 211 and the bottom surface 212 on the inner surface 210 of the housing 21, and the first plate portion 232 of the positive electrode conductor 23 and the second plate portion 242 of the negative electrode conductor 24 can be shortened. In addition, the distance between the first connecting portion 233b of the P bus bar 233 in the positive electrode conductor 23 and the second connecting portion 243b of the N bus bar 243 in the negative electrode conductor 24 can be shortened. As a result, it is possible to increase the amount of magnetic flux linking with the top surface 211 and the bottom surface 212 of the inner surface 210 of the housing 21, within the magnetic flux generated by the current flowing through the first plate portion 232 and the second plate portion 242, and the amount of magnetic flux linking with the conductive plate 26, 26a, thereby reducing the inductance. Although detailed illustration is omitted, the conductor insulating layer 29 may be disposed on the outer surfaces of the first conductor 20a and the second conductor 20b of the external input conductor 20.

In addition, the conductive plate 26, 26a described in the above embodiment may be configured such that the conductive plate 26, 26a is not formed integrally with the housing 21 and are positioned in the housing 21 by the insulation portion 25.

In addition, the capacitor element 22 of the capacitor 2 described in the above embodiment is not limited to a film capacitor. The capacitor element 22 may be, for example, an electrolytic capacitor or the like.

Further, the capacitor element 22 described in the above embodiment has the positive electrodes 22p disposed on the upper surface 22a and the negative electrodes 22n disposed on the lower surface 22b, but the present invention is not limited to this configuration. The capacitor element 22 may include negative electrodes 22n disposed on the upper surface 22a and positive electrodes 22p disposed on the lower surface 22b.

In this case, the first plate portion 232 of the positive electrode conductor 23 need only be connected to the positive electrodes 22p disposed on the lower surface 22b, and the first conductor 20a and the P bus bar 233 of the positive electrode conductor 23 need only be connected to the first plate portion 232. In addition, the second plate portion 242 of the negative electrode conductor 24 need only be connected to the negative electrodes 22n disposed on the upper surface 22a, and the second conductor 20b and the N bus bar 243 of the negative electrode conductor 24 need only be connected to the second plate portion 242.

Accordingly, the respective arrangements of the first conductor 20a and the positive electrode conductor 23 and the respective arrangements of the second conductor 20b and the negative electrode conductor 24 described in the above embodiment may be replaced with each other. Even in this case, the first connecting portion 233b of the P bus bar 233 need only be connected to the P terminal 331 of the power module 30, and the second connecting portion 243b of the N bus bar 243 need only be connected to the N terminal 332 of the power module 30.

In addition, in the above embodiment, the configuration in which the conductive plate 26, 26a is formed of the same material as the housing 21 has been described, but the present disclosure is not limited to this configuration. The conductive plate 26, 26a may be formed of a metallic material having a higher heat conductivity than the metallic material forming the housing 21.

In addition, the terms "parallel", "perpendicular", and "the same shape" described in the above embodiment refer to a state in which the lines are substantially parallel, perpendicular, and the same shape, respectively, and slight manufacturing errors, design tolerances, and the like are allowed. A configuration slightly inclined from a parallel state and a vertical state may also be possible.

In the above embodiment, the inverter is described as an example of the power conversion device 100. However, the power conversion device 100 is not limited to the inverter. The power conversion device 100 may be, for example, a device that performs power conversion by means of the power semiconductor element 323, such as a converter or a combination of an inverter and a converter. When the power conversion device 100 is a converter, an AC voltage may be input from an external input power supply (not illustrated) or the like to an external output conductor 34, the power semiconductor element 323 on the circuit board 32 may convert the AC voltage into a DC voltage, and the DC voltage from the power semiconductor element 323 may be output to the outside of the power conversion device 100 through the positive electrode conductor 23 and the negative electrode conductor 24.

### [Appendix]

The power module connection capacitor and the power conversion device described in each embodiment are understood as follows, for example.

(1) A power module connection capacitor 2 according to a first aspect includes: a housing 21; a plurality of capacitor elements 22 that are housed in the housing 21 and are disposed adjacent to each other; a positive electrode conductor 23 that connects positive electrodes 22p of the plurality of capacitor elements 22 and positive electrodes of power modules 30 disposed outside the housing 21; a negative electrode conductor 24 that connects negative electrodes 22n of the plurality of capacitor elements 22 and negative electrodes of the power modules 30, in a state where the plurality of capacitor elements 22 are held between the positive electrode conductor 23 and the negative electrode conductor 24; an insulation portion 25 housed in the housing 21 and disposed to fill respective spaces formed between an inner surface 210 of the housing 21, the plurality of capacitor elements 22, the positive electrode conductor 23, and the negative electrode conductor 24, thereby insulating the housing 21, the capacitor elements 22, the positive electrode conductor 23, and the negative electrode conductor 24 from each other; and a conductive plate 26, 26a housed in the housing 21, and disposed between a current path of the positive electrode conductor 23 extending from the capacitor elements 22 to the power modules 30 and a current path of the negative electrode conductor 24 extending from the capacitor elements 22 to the power modules 30, via the positive electrode conductor 23, the negative electrode conductor 24, and the insulation portion 25, in which the conductive plate 26, 26a is formed of a material with higher heat conductivity than the insulation portion 25.

Accordingly, since the conductive plate 26, 26a is disposed between the current paths of the positive electrode conductor 23 and the negative electrode conductor 24, the magnetic flux generated by the current flowing through each current path links with the conductive plate 26, 26a. Since the magnetic flux links with the conductive plate 26, 26a, an induced current (back electromotive force) in accordance with the amount of the linked magnetic flux flows through the conductive plate 26, 26a, and the magnetic flux from each current path is canceled out by the magnetic flux generated by the induced current. Further, since the heat conductivity is higher than the thermal conductive property of the insulation portion 25, the heat generated from each current path can spread more in the housing 21 as compared to a configuration in which the conductive plate 26, 26a is not disposed between the current paths.

(2) The power module connection capacitor 2 according to a second aspect is the power module connection capacitor 2 according to the first aspect, in which the conductive plate 26a may have a first portion 261 disposed between the current path of the positive electrode conductor 23 and the current path of the negative electrode conductor 24 on a side of the power modules 30, with respect to the capacitor elements 22, and a second portion 262 formed integrally with the first portion 261 and disposed between the adjacent capacitor elements 22.

Accordingly, since the second portion 262 of the conductive plate 26a is disposed between the capacitor elements 22 adjacent to each other, the magnetic flux generated by the current flowing through the capacitor elements 22 links with the second portion 262. Since the magnetic flux links with the second portion 262, an induced current (back electromotive force) in accordance with the amount of the linked magnetic flux flows through the second portion 262, and the magnetic flux from the capacitor elements 22 is canceled out by the magnetic flux generated by the induced current.

(3) The power conversion device 100 according to a third aspect includes the power module connection capacitor 2 according to the first aspect or the second aspect, the power modules 30, and a cooler 4 that cools the power module connection capacitor 2 and the power modules 30, in which the housing 21 is connected to the cooler 4, and the conductive plate 26, 26a is disposed integrally with the housing 21.

Accordingly, the housing 21 is cooled by the cooler 4 while the heat conducted to the conductive plate 26, 26a from the current path of the positive electrode conductor 23 and the current path of the negative electrode conductor 24 is released to the housing 21.

### Industrial Applicability

According to the present disclosure, it is possible to provide a power module connection capacitor and a power conversion device capable of suppressing occurrence of inductance in a conductor that connects capacitor elements and power modules while suppressing an increase in temperature of the conductor.

### Reference Signs List

1: casing
1a: input side surface
1b: output side surface
2: power module connection capacitor (capacitor)
3: power conversion unit
4: cooler
20: external input conductor
20a: first conductor
20b: second conductor
21: housing
22: capacitor element
22a: upper surface
22b: lower surface
22p: positive electrode
22n: negative electrode
23: positive electrode conductor
24: negative electrode conductor
25: insulation portion
26, 26a: conductive plate
27: housing insulating layer
28: conductive plate insulating layer
29: conductor insulating layer
30: power module
31: base plate
31a: front surface
31b: back surface
32: circuit board
33: main terminal portion
34: external output conductor
35: resin case
36: sealing portion
41: base portion
41a: bonding surface
41b: heat dissipation surface
42: heat dissipation fin
100: power conversion device
210: inner surface
211: top surface
212: bottom surface
213: side surface
232: first plate portion
232a, 242a: outer edge portion
233: P bus bar
233a: first hanging-down portion
233b: first connecting portion
242: second plate portion
243: N bus bar
243a: second hanging-down portion
243b: second connecting portion
261: first portion
262: second portion
321: insulating plate
321a: first surface
321b: second surface
322: front surface pattern
322a: first front surface pattern
322b: second front surface pattern
322c: third front surface pattern
323: power semiconductor element
323a: first power semiconductor element
323b: second power semiconductor element
331: P terminal
332: N terminal
G: gap
Rp: potting space
S: interval
W: liquid refrigerant
Wb: bonding wire

## Claims

1. A power module connection capacitor comprising:
a housing;
a plurality of capacitor elements that are housed in the housing and are disposed adjacent to each other;
a positive electrode conductor that connects positive electrodes of the plurality of capacitor elements and positive electrodes of power modules disposed outside the housing;
a negative electrode conductor that connects negative electrodes of the plurality of capacitor elements and negative electrodes of the power modules, in a state where the plurality of capacitor elements are held between the positive electrode conductor and the negative electrode conductor;
an insulation portion housed in the housing and disposed to fill respective spaces formed between an inner surface of the housing, the plurality of capacitor elements, the positive electrode conductor, and the negative electrode conductor, thereby insulating the housing, the capacitor elements, the positive electrode conductor, and the negative electrode conductor from each other; and
a conductive plate housed in the housing, and disposed between a current path of the positive electrode conductor extending from the capacitor elements to the power modules and a current path of the negative electrode conductor extending from the capacitor elements to the power modules, via the positive electrode conductor, the negative electrode conductor, and the insulation portion,
wherein the conductive plate is formed of a material with higher heat conductivity than the insulation portion.

2. The power module connection capacitor according to Claim 1,
wherein the conductive plate has
a first portion disposed between the current path of the positive electrode conductor and the current path of the negative electrode conductor on a side of the power modules, with respect to the capacitor elements, and
a second portion formed integrally with the first portion and disposed between the adjacent capacitor elements.

3. A power conversion device comprising:
the power module connection capacitor according to Claim 1 or 2;
the power modules; and
a cooler that cools the power module connection capacitor and the power modules,
wherein the housing is connected to the cooler, and
the conductive plate is disposed integrally with the housing.
